# EUROPEAN PATENT APPLICATION

(11) **EP 4 394 772 A1**
(43) Date of publication of application: **03.07.2024**
(21) Application number: 22934532.7
(22) Date of filing: 08.06.2022
(51) Int. Cl.: G11C 11/407

(54) **MEMORY AND MANUFACTURING METHOD THEREFOR, AND ELECTRONIC DEVICE**

(30) Priority: 02.04.2022 CN 202210351082
(71) Applicant: Beijing Superstring Academy of Memory Technology, Beijing 100176 (CN)
(72) Inventor: ZHU, Zhengyong, Beijing 100176 (CN); KANG, Bokmoon, Beijing 100176 (CN); WANG, Guilei, Beijing 100176 (CN); ZHAO, Chao, Beijing 100176 (CN)
(74) Representative: Cabinet Beau de Loménie
(86) International application number: PCT/CN2022/097706
(87) International publication number: WO 2023/184707

(57) **Abstract**

Embodiments of the present invention provide a memory and a manufacturing method therefor, and an electronic device. The memory comprises a substrate, and a word line, a bit line and a storage unit on one side of the substrate. The storage unit comprises a transistor. The transistor comprises: a semiconductor layer which comprises a source contact region, a semiconductor region, and a drain contact region which are sequentially connected; a main gate electrically connected to the word line; a source electrically connected to the bit line and the source contact region of the semiconductor layer, respectively; a drain electrically connected to the drain contact region of the semiconductor layer; and a secondary gate electrically connected to the drain. The orthographic projection of the main gate on the substrate and the orthographic projection of the secondary gate on the substrate at least partially overlap with the orthographic projection of the semiconductor region of the semiconductor layer on the substrate. According to the present invention, on the basis that the transistor has the main gate, the secondary gate electrically connected to the drain is introduced, the secondary gate can obtain a fixed potential synchronous with the drain, and provide supplement control for the semiconductor layer by utilizing the fixed potential, thereby optimizing the read-write performance of the memory.

## Description

### CORRS-REFERENCE TO RELATED APPLICATION

This application is based upon and claims priority to Chinese Patent Application No. 202210351082.9, filed on April 2, 2022, the disclosure of which is herein incorporated by reference in its entirety.

### TECHNICAL FIELD

The present disclosure relates to the field of memory technologies, and in particular, relates to a memory and a method for manufacturing the same, and an electronic device.

### BACKGROUND

Random access memory (RAM) typically includes a transistor and a storage structure, such as a capacitor. The transistor provides control of the storage structure for reading or writing. As can be seen from the above, the performance of the transistor has a significant impact on the reading and writing performance of the entire memory.

### SUMMARY

Embodiments of the present disclosure provide a memory and a method for manufacturing the same, and an electronic device to improve the reading and writing performance of the memory.

In one aspect, the present disclosure provides a memory. The memory includes a substrate, and a word line, a bit line, and a storage unit that are disposed on a side of the substrate; wherein the storage unit includes a transistor, the transistor including: a semiconductor layer, including a source contact region, a semiconductor region, and a drain contact region that are successively connected; a main gate electrode, electrically connected to the word line; a source electrode, electrically connected to the bit line and the source contact region of the semiconductor layer; a drain electrode, electrically connected to the drain contact region of the semiconductor layer; a secondary gate electrode, electrically connected to the drain electrode; wherein an orthographic projection of the main gate electrode on the substrate and an orthographic projection of the secondary gate electrode on the substrate are each at least partially overlapped with an orthographic projection of the semiconductor region of the semiconductor layer on the substrate.

In some embodiments, the main gate electrode is disposed between the substrate and the semiconductor layer; or the main gate electrode is disposed on a side, away from the substrate, of the semiconductor layer.

In some embodiments, the main gate electrode and the secondary gate electrode are respectively disposed on opposite sides of the semiconductor layer.

In some embodiments, the storage unit further includes a storage structure; wherein the storage structure includes a capacitance storage structure formed between the secondary gate electrode and a first electrode.

In some embodiments, the first electrode is the source electrode, and an orthographic projection of the source electrode on the substrate is partially overlapped with the orthographic projection of the secondary gate electrode on the substrate.

In some embodiments, the main gate electrode is disposed on a side, away from the substrate, of the semiconductor layer, the secondary gate electrode is disposed between the substrate and the semiconductor layer, and the first electrode is disposed between the substrate and the secondary gate electrode.

In some embodiments, the main gate electrode is disposed between the substrate and the semiconductor layer, the secondary gate electrode is disposed on a side, away from the substrate, of the semiconductor layer, and the first electrode is disposed on a side, away from the substrate, of the secondary gate electrode.

In some embodiments, the transistor further includes: a first dielectric layer disposed between the semiconductor layer and the main gate electrode; and a second dielectric layer disposed between the secondary gate electrode and the semiconductor layer and disposed between the secondary gate electrode and the source electrode, wherein an orthographic projection of the source electrode on the substrate is partially overlapped with the orthographic projection of the secondary gate electrode on the substrate.

In some embodiments, the main gate electrode is disposed on a side, away from the substrate, of the semiconductor layer, and the secondary gate electrode is disposed between the substrate and the semiconductor layer; and the transistor further includes a first insulative layer, a first via, and a second via; wherein the first insulative layer is disposed on a side, away from the substrate, of the main gate electrode; the bit line is disposed on a side, away from the main gate electrode, of the first insulative layer; the first via runs through the first insulative layer and the first dielectric layer and is connected to the bit line and the source contact region of the semiconductor layer, wherein at least a portion of an entirety including the first via and the source contact region of the semiconductor layer forms the source electrode; and the second via runs through the first insulative layer, the first dielectric layer, and the second dielectric layer and is connected to the drain contact region of the semiconductor layer and the secondary gate electrode, wherein at least a portion of an entirety including the second via and the drain contact region of the semiconductor layer forms the drain electrode.

In some embodiments, the main gate electrode is disposed between the substrate and the semiconductor layer, and the secondary gate electrode is disposed on a side, away from the substrate, of the semiconductor layer; and the transistor further includes a first insulative layer, a first via, and a second via; wherein the first insulative layer is disposed on a side, away from the substrate, of the secondary gate electrode; the bit line is disposed on a side, away from the secondary gate electrode, of the first insulative layer; the first via runs through the first insulative layer and the second dielectric layer and is connected to the bit line and the source contact region of the semiconductor layer, wherein at least a portion of an entirety including the first via and the source contact region of the semiconductor layer forms the source electrode; and the second via runs through the first insulative layer and the second dielectric layer and is connected to the secondary gate electrode and the drain contact region of the semiconductor layer, wherein at least a portion of an entirety including the second via and the drain contact region of the semiconductor layer forms the drain electrode.

In some embodiments, the word line is disposed in a same layer as the main gate electrode and is disposed in a different layer from the bit line.

In some embodiments, the semiconductor layer includes at least one material of a metal oxide semiconductor, monocrystalline silicon, polycrystalline silicon, or amorphous silicon; wherein the metal oxide semiconductor includes at least one of indium, gallium, zinc, tin, or tungsten.

In some embodiments, at least two of the storage units are stacked in a direction perpendicular to the substrate; and/or at least two of the storage units are arranged in an array on a side of the substrate, wherein the main gate electrodes of the transistors in at least two of the storage units disposed in a same row are electrically connected to a same one of the word lines, and the source electrodes of the transistors in at least two of the storage units disposed in a same column are electrically connected to a same one of the bit lines.

In a second aspect, the present disclosure provides an electronic device. The electronic device includes the memory as described above.

In a third aspect, the present disclosure provides a method for manufacturing a memory. The method includes: successively preparing a secondary gate electrode, a second dielectric layer, a semiconductor layer, a first dielectric layer, a main gate electrode, a word line connected to the main gate electrode, and a first insulative layer on a side of a substrate; wherein the semiconductor layer includes a source contact region, a semiconductor region, and a drain contact region that are successively connected; acquiring a first through-via exposing at least a portion of the source contact region of the semiconductor layer by successively etching the first insulative layer and the first dielectric layer; acquiring a second through-via exposing at least a portion of the drain contact region of the semiconductor layer and a portion of the secondary gate electrode by successively etching the first insulative layer, the first dielectric layer, and the second dielectric layer; forming a first via connected to the source contact region of the semiconductor layer within the first through-via and a second via connecting the secondary gate electrode to the drain contact region of the semiconductor layer within the second through-via by manufacturing conductive materials within the first through-via and the second through-via, respectively; and manufacturing a bit line in the first via.

In some embodiments, successively preparing the secondary gate electrode, the second dielectric layer, the semiconductor layer, the first dielectric layer, the main gate electrode, the word line connected to the main gate electrode, and the first insulative layer on the side of the substrate includes: preparing the secondary gate electrode on the side of the substrate; preparing the second dielectric layer on the secondary gate electrode and the substrate exposed; preparing the semiconductor layer on the second dielectric layer, such that an orthographic projection of the semiconductor region of the semiconductor layer on the substrate and an orthographic projection of the source contact region of the semiconductor layer on the substrate are each partially overlapped with an orthographic projection of the secondary gate electrode on the substrate; and conducting the source contact region and the drain contact region of the semiconductor layer.

In some embodiments, acquiring the first through-via exposing at least a portion of the source contact region of the semiconductor layer by successively etching the first insulative layer and the first dielectric layer and acquiring the second through-via exposing at least a portion of the drain contact region of the semiconductor layer and a portion of the secondary gate electrode by successively etching the first insulative layer, the first dielectric layer, and the second dielectric layer are performed synchronously.

In a fourth aspect, the present disclosure provides a method for manufacturing a memory. The method includes: successively preparing a main gate electrode, a word line connected to the main gate electrode, a first dielectric layer, a semiconductor layer, a second dielectric layer, a secondary gate electrode, and a first insulative layer on a side of a substrate; wherein the semiconductor layer includes a source contact region, a semiconductor region, and a drain contact region that are successively connected; acquiring a first through-via exposing at least a portion of the source contact region of the semiconductor layer by successively etching the first insulative layer and the second dielectric layer; acquiring a second through-via exposing a portion of the secondary gate electrode and at least a portion of the drain contact region of the semiconductor layer by successively etching the first insulative layer and the second dielectric layer; forming a first via connected to the source contact region of the semiconductor layer in the first through-via and a second via connecting the secondary gate electrode to the drain contact region of the semiconductor layer in the second through-via by respectively manufacturing conductive materials in the first through-via and the second through-via; and manufacturing a bit line in the first via.

In some embodiments, successively preparing the main gate electrode, the word line connected to the main gate electrode, the first dielectric layer, the semiconductor layer, the second dielectric layer, the secondary gate electrode, and the first insulative layer on the side of the substrate includes: preparing the main gate electrode and the word line connected to the main gate electrode on the side of the substrate; preparing the first dielectric layer on the main gate electrode, the word line connected to the main gate electrode, and the exposed substrate; preparing the semiconductor layer on the first dielectric layer, such that an orthographic projection of the semiconductor region of the semiconductor layer on the substrate is partially overlapped with an orthographic projection of the main gate electrode on the substrate; conducting the source contact region and the drain contact region of the semiconductor layer; preparing the second dielectric layer on the semiconductor layer and the exposed first dielectric layer; and preparing the secondary gate electrode on the second dielectric layer, such that an orthographic projection of the secondary gate electrode on the substrate is partially overlapped with the orthographic projection of the semiconductor region of the semiconductor layer on the substrate and an orthographic projection of the source contact region of the semiconductor layer on the substrate

In some embodiments, acquiring the first through-via exposing at least a portion of the source contact region of the semiconductor layer by successively etching the first insulative layer and the second dielectric layer and acquiring the second through-via exposing a portion of the secondary gate electrode and at least a portion of the drain contact region of the semiconductor layer by successively etching the first insulative layer and the second dielectric layer are performed synchronously.

The technical solutions according to the embodiments of the present disclosure achieve at least the following beneficial effects. The structure of the memory is optimized. Specifically, the transistor, on the basis of including the main gate electrode capable of controlling the conductivity of the semiconductor layer, the secondary gate electrode which is also capable of controlling the conductivity of the semiconductor layer is introduced. The secondary gate electrode is electrically connected to the drain electrode, such that the secondary gate electrode acquires a constant potential synchronized with the drain electrode and provides supplementary control to the semiconductor layer by using the constant potential. Further, the secondary gate electrode is not electrically connected to the source electrode, such that the secondary gate electrode serves as the negative bias of the threshold voltage in the reading stage. In this way, the performance of the transistor is improved, and thus the reading and writing performance of the memory is optimized.

The reading and writing performance is improved by connecting the back gate electrode to the drain electrode. The secondary gate electrode is not connected to any electrode other than the drain electrode. The secondary gate electrode is disposed on the other side of the semiconductor layer, and the secondary gate electrode and the main gate electrode are disposed on both sides of the semiconductor layer. The back gate electrode of the present application is not a floating gate electrode, and there must be a constant potential and the potential must be synchronized with the drain electrode, which applies to the reading and writing scenarios for memory. The back gate electrode of the present application is not connected to the source electrode, and the secondary gate electrode serves as the negative bias of Vth during the reading stage.

Additional aspects and advantages of the present disclosure will be partially described hereinafter, and these will be apparent from the following description or learned through the practice of the present application.

### BRIEF DESCRIPTION OF DRAWINGS

The above-mentioned and/or additional aspects and advantages of the present disclosure will become apparent and readily understood from the following description of embodiments in conjunction with the accompanying drawings, wherein:
FIG. 1 is a circuit schematic of a storage unit in the related art;
FIG. 2 is a circuit schematic of a memory according to some embodiments of the present disclosure;
FIG. 3 is a circuit schematic of a storage unit according to some embodiments of the present disclosure;
FIG. 4 is a schematic structural diagram of a memory according to some embodiments of the present disclosure;
FIG. 5 is a schematic structural diagram of an implementation I of a storage unit according to some embodiments of the present disclosure;
FIG. 6 is another schematic structural diagram of an implementation II of a storage unit according to some embodiments of the present disclosure;
FIG. 7 is a schematic structural diagram of an implementation III of a storage unit according to some embodiments of the present disclosure;
FIG. 8 is a schematic structural diagram of an implementation IV of a storage unit according to some embodiments of the present disclosure;
FIG. 9 is a frame schematic structural diagram of an electronic device according to some embodiments of the present disclosure;
FIG. 10 is a flowchart of a method for manufacturing a memory according to some embodiments of the present disclosure;
FIG. 11 is a flowchart of another method for manufacturing a memory according to some embodiments of the present disclosure;
FIG. 12 is a schematic diagram of a film-layer structure after step S301 in a specific method for manufacturing a memory according to some embodiments of the present disclosure;
FIG. 13 is a schematic diagram of a film-layer structure after step S302 in a specific method for manufacturing a memory according to some embodiments of the present disclosure;
FIG. 14 is a schematic diagram of a film-layer structure after step S303 in a specific method for manufacturing a memory according to some embodiments of the present disclosure;
FIG. 15 is a schematic diagram of a film-layer structure after step S304 in a specific method for manufacturing a memory according to some embodiments of the present disclosure;
FIG. 16 s is a schematic diagram of a film-layer structure after step S305 in a specific method for manufacturing a memory according to some embodiments of the present disclosure;
FIG. 17 is a schematic diagram of a film-layer structure after step S306 in a specific method for manufacturing a memory according to some embodiments of the present disclosure;
FIG. 18 is a schematic diagram of a film-layer structure after step S307 in a specific method for manufacturing a memory according to some embodiments of the present disclosure;
FIG. 19 is a schematic diagram of a film-layer structure after step S308 in a specific method for manufacturing a memory according to some embodiments of the present disclosure;
FIG. 20 is a schematic diagram of a film-layer structure after step S309 in a specific method for manufacturing a memory according to some embodiments of the present disclosure;
FIG. 21 is a schematic diagram of a film-layer structure after step S310 in a specific method for manufacturing a memory according to some embodiments of the present disclosure; and
FIG. 22 is a graph of the transfer characteristics of a transistor when different data is written to the memory according to the present disclosure.

Reference numerals and denotations thereof:
10-storage unit; 101-secondary gate electrode; 102-second dielectric layer; 103-semiconductor layer; 1031-source contact region; 1032-drain contact region; 1033-semiconductor region; 104-first dielectric layer; 105-main gate electrode; 106-first insulative layer; 107-first via; 108-second via; 109-planarization layer; 110-first electrode; 20-bit line; 30-word line; 100- storage unit group; 200-substrate; 300-buffer layer; 1-memory; 2-electronic device.

### DETAILED DESCRIPTION

Embodiments of the present disclosure are described hereinafter in conjunction with the accompanying drawings of the present disclosure. It should be understood that the embodiments described in conjunction with the accompanying drawings are exemplary descriptions for explaining the technical solutions of the embodiments of the present disclosure, and do not constitute any limitation to the technical solutions of the embodiments of the present disclosure.

It should be understood by those skilled in the art that, unless otherwise defined, the singular forms "one," "a," "the," and "the" used herein may also include the plural forms. It should be further understood that the term "include" used herein refers to the presence of the described features, integers, steps, operations, elements, and/or components, but does not preclude the presence or addition of one or more other features, integers, steps, operations, elements, components, and/or groups thereof. It should be understood that when a component is "connected" or "coupled" to another component, it may be directly connected or coupled to the other component, or there may be intermediate components. Furthermore, "connected" or "coupled" used herein may include wirelessly connected or wirelessly coupled. The term "and/or" used herein includes all or any of the units and all combinations of one or more associated listed items. For example, "A and/or B" may be implemented as "A," or "B," or "A and B."

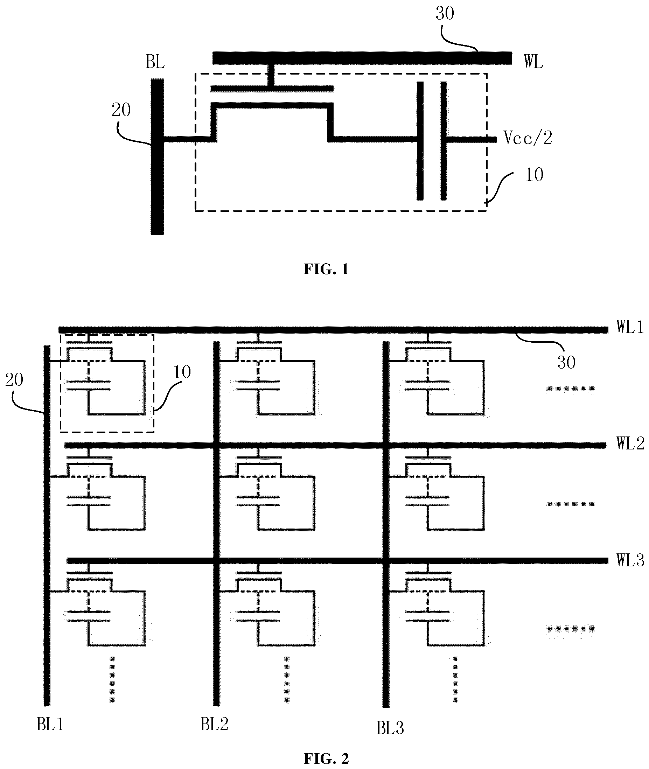

The idea of the development of the present disclosure includes the following. As shown in FIG. 1, a storage unit 10 of the DRAM is usually composed of a transistor and a capacitor, i.e., in a 1T1C structure. Since there is current leakage across the channel in the off state of the transistor, the charges stored in the capacitor are gradually lost. Thus, it is generally necessary to perform the frequent refresh to ensure the validity of the stored data.

At present, to reduce the refresh rate, the mainstream DRAM is conventionally designed to have a large enough capacitor. As a result, the structure of the DRAM is not compact and the integration degree is low.

In some embodiments of the present disclosure, the provided memory 1 is an access memory 1. The access memory 1 includes storage arrays, and each of the storage arrays includes a storage unit 10, such as a storage unit 10 in a storage array of a dynamic random access memory (DRAM) 1 or other types of memory 1.

In addition to the storage unit 10 in the storage array, the storage unit 10 may be at least one of a plurality of storage units 10 that are in a non-array form.

Each storage array at least includes storage units 10 distributed in rows and columns. Each of the storage units 10 includes at least one transistor, at least one word line 30, and at least one bit line 20.

In some embodiments, the storage unit 10 includes one transistor, one memory 1, one word line 30, and one bit line 20.

In other embodiments, the storage unit 10, while including only one transistor, also includes two bit lines 20.

In yet other embodiments, more than one transistors are provided.

In the storage unit 10 of the present disclosure, the transistor, in addition to having the main gate electrode 105 that controls the conductivity of the semiconductor layer 103, is introduced with the secondary gate electrode 101 that also controls the conductivity of the semiconductor layer 103. The secondary gate electrode 101 is electrically connected to the drain electrode, such that the secondary gate electrode 101 acquires a constant potential synchronized with the drain electrode and provides supplementary control to the conductivity of the semiconductor layer 103 using the constant potential. The secondary gate electrode 101 is not electrically connected to the source electrode, such that the secondary gate electrode 101 serves as a negative bias of the threshold voltage during the reading stage, which improves the performance of the transistor and thus optimizes the reading and writing performance of the memory 1.

The inventive concepts of the present application are explained and illustrated hereinafter by specific examples.

A memory and a method of manufacturing the same, and an electronic device provided by the present application are intended to solve the technical problems in the related art as described above. According to some embodiments of the present disclosure, a memory 1 is provided 1. As shown in FIG. 2 to FIG. 8, the memory 1 includes a substrate 200, and a word line 30, a bit line 20, and a storage unit 10 that are disposed on a side of the substrate 200.

The storage unit 10 includes a transistor. The transistor includes a semiconductor layer 103, a main gate electrode 105, a source electrode, a drain electrode, and a secondary gate electrode 101.

The semiconductor layer 103 includes a source contact region 1031, a semiconductor region 1033, and a drain contact region 1032 that are successively connected.

The main gate electrode 105 is electrically connected to the word line 30.

The source electrode is electrically connected to the bit line 20 and the source contact region 1031 of the semiconductor layer 103.

The drain electrode is electrically connected to the drain contact region 1032 of the semiconductor layer 103.

The secondary gate electrode 101 is electrically connected to the drain electrode.

An orthographic projection of the main gate electrode 105 on the substrate 200 and an orthographic projection of the secondary gate electrode 101 on the substrate 200 are each at least partially overlapped with an orthographic projection of the semiconductor region 1033 of the semiconductor layer 103 on the substrate 200.

The memory 1 according to some embodiments optimizes the structure of the memory 1. Specifically, on the basis that the transistor includes the main gate electrode 105 capable of controlling the conductivity of the semiconductor layer 103, the secondary gate electrode 101 which is also capable of controlling the conductivity of the semiconductor layer 103 is introduced. The secondary gate electrode 101 is electrically coupled to the drain electrode, such that the secondary gate electrode 101 acquires a constant potential synchronized with the drain electrode and provides supplementary control to the semiconductor layer 103 using the constant potential. Furthermore, the secondary gate electrode 101 is not electrically connected to the source electrode, such that the secondary gate electrode 101 serves as a negative bias of the threshold voltage during the reading stage, which improves the performance of the transistor and thus optimizes the reading and writing performance of the memory 1.

It should be noted that the secondary gate electrode 101 in the embodiments is electrically connected to the drain electrode and acquires the constant potential synchronized with the drain electrode, and thus the secondary gate electrode 101 is not a floating gate electrode.

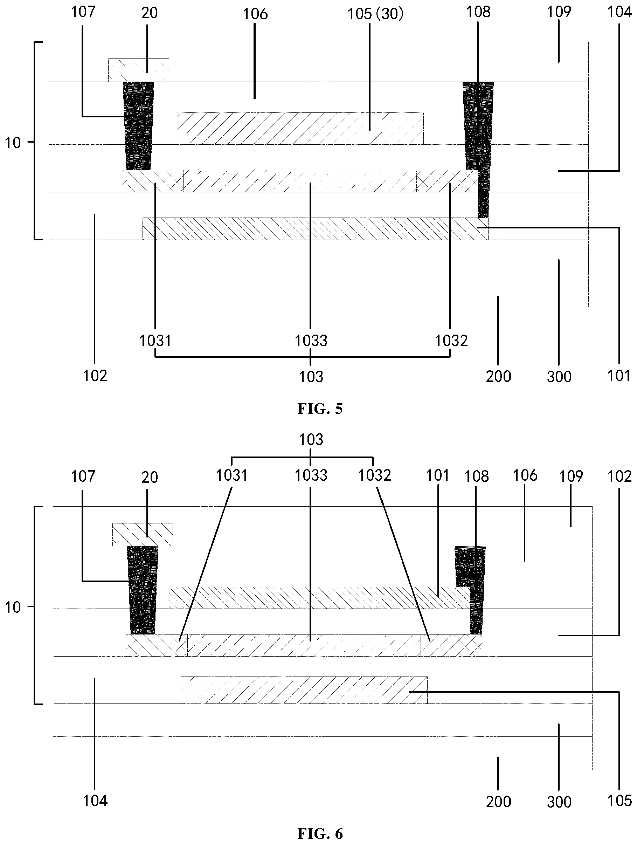

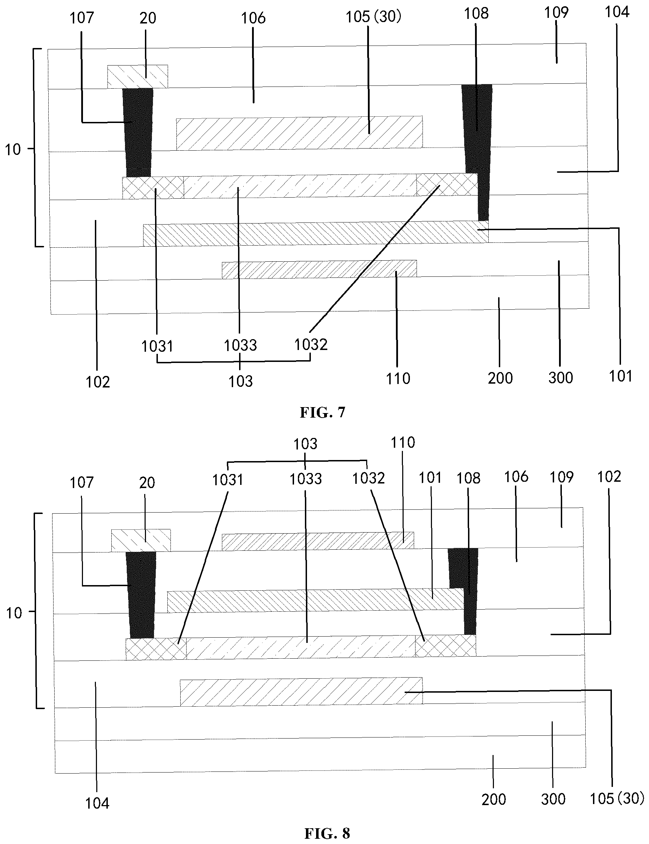

In some embodiments, as shown in FIG. 6 and FIG. 8, the main gate electrode 105 is disposed between the substrate 200 and the semiconductor layer 103. That is, the transistor is in a bottom-gate structure.

In other embodiments, as shown in FIG. 5 and FIGS. 7, the main gate electrode 105 is disposed on a side, away from the substrate 200, of the semiconductor layer 103. That is, the transistor is in a top-gate structure.

Based on the possible embodiments described above, in yet other embodiments, as shown in FIG. 5 to FIG. 8, the main gate electrode 105 and the secondary gate electrode 101 are disposed on opposite sides of the semiconductor layer 103. In this way, the mutual interference between the main gate electrode 105 and the secondary gate electrode 101 is reduced, and it is conducive to increasing an effective area of the main gate electrode 105 and the secondary gate electrode 101 respectively acting on the semiconductor layer 103, such that the performance of the transistor is improved. Specifically, in a case where the transistor adopts the bottom-gate structure, the main gate electrode 105 is disposed between the substrate 200 and the semiconductor layer 103, and the secondary gate electrode 101 is disposed on the side, away from the substrate 200, of the semiconductor layer 103. In a case where the transistor adopts the top-gate structure, the secondary gate electrode 101 is disposed between the substrate 200 and the semiconductor layer 103, and the main gate electrode is disposed on the side, away from the substrate 200, of the semiconductor layer 103.

The idea of the development of the present disclosure also includes the following. The storage unit 1 of the dynamic random access memory 1 (DRAM) typically includes the transistor and the storage structure such as the capacitor, e.g., in the 1T1C structure. The capacitor is typically implemented by the capacitive electrode. Since there is current leakage across the channel in the off state of the transistor, at least a portion of the charges stored in the capacitor is gradually lost in the form of leakage current. Thus the stored data needs to be frequently refreshed to ensure validity of the stored data. In DRAM products, the refresh rate is reduced by increasing the area of the capacitive electrodes to increase the storage capacitance, but the increase of the area of the capacitive electrode reduces the integration degree of the DRAM product.

To this end, the present application provides a possible implementation of the memory 1 as follows.

As shown in FIG. 7 and FIG. 8, in some embodiments according to the present disclosure, the storage unit 10 further includes a storage structure. The storage structure includes a capacitance storage structure formed between the secondary gate electrode 101 and the first electrode 107.

In the embodiments, the storage unit 10 includes the capacitance storage structure formed between the secondary gate electrode 101 and the first electrode 107, which achieves the writing of data and also improves the current leakage in the off state of the transistor. The device has a high degree of integration by using the secondary electrode as part of the capacitance storage structure.

Optionally, the first electrode 107 is a specialized conductive structure that forms the capacitance storage structure with the secondary gate electrode 101, or a conductive structure that has conductivity and forms the capacitance storage structure with the secondary gate electrode 101 in other electrical structures within the memory 1.

In some embodiments, as shown in FIG. 7, the main gate electrode 105 is disposed on the side, away from the substrate 200, of the semiconductor layer 103, the secondary gate electrode 101 is disposed between the substrate 200 and the semiconductor layer 103, and the first electrode 107 is disposed between the substrate 200 and the secondary gate electrode 101. That is, in a case where the main gate electrode 105 and the secondary gate electrode 101 are respectively disposed on two sides of the semiconductor layer 103 and the transistor is in the top-gate structure, the first electrode 107 is disposed closer to the substrate 200 relative to the secondary gate electrode 101.

In some embodiments, as shown in FIG. 8, the main gate electrode 105 is disposed between the substrate 200 and the semiconductor layer 103, the secondary gate electrode 101 is disposed on the side, away from the substrate 200, of the semiconductor layer 103, and the first electrode 107 is disposed on a side, away from the substrate 200, of the secondary gate electrode 101. That is, in a case where the main gate electrode 105 and the secondary gate electrode 101 are respectively disposed on two sides of the semiconductor layer 103 and the transistor is in the bottom-gate structure, the first electrode 107 is further away from the substrate 200 relative to the secondary gate electrode 101.

In some embodiments, as shown in FIG. 5 and FIG. 6, the first electrode 107 is the source electrode, and an orthographic projection of the source electrode on the substrate 200 is partially overlapped with an orthographic projection of the secondary gate electrode 101 on the substrate 200.

In the embodiments, the source electrode is utilized as another part of the capacitance storage structure to cooperate with the secondary gate electrode 101 to achieve the writing of data, such that the integration degree of the memory 1 is further improved. That is, the reading and writing of data are achieved by providing only one transistor in the storage unit 10 of the memory 1, and there is no need to provide other transistors or capacitors, which greatly simplifies the structure of the storage unit 10 and is conducive to improving the integration degree and storage density of the memory 1.

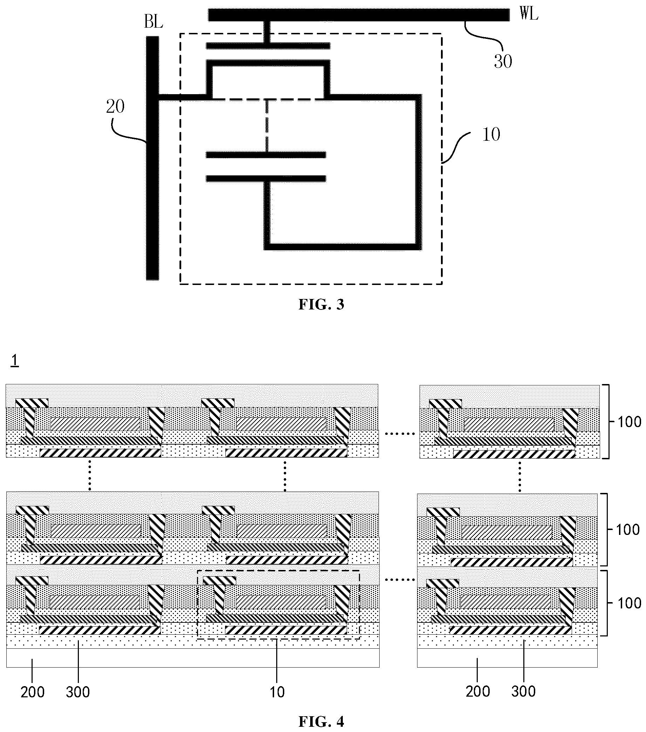

It should be noted that although a storage capacitor is illustrated in both FIG. 2 and FIG. 3, the storage capacitor is constituted by the secondary gate electrode 101 in the transistor and the source electrode and drain electrode in the transistor. Because the secondary gate electrode 101 has a back-gate effect, i.e., a potential of the secondary gate electrode 101 affects a threshold voltage of the transistor, the magnitude of s voltage used to turn on the transistor when reading the stored data is between a threshold voltage of the transistor when storing "1" and a threshold voltage of the transistor when storing "0."

The memory 1 according to the embodiment applies a first level to the main gate electrode 105 by the word line 30 during the writing operation and transmits a storage signal to the source electrode of the to-be-written storage unit 10 by the bit line 20. The source electrode transmits the storage signal to the drain electrode, the drain electrode transmits the storage signal to the secondary gate electrode 101, and node capacitors of the secondary gate electrode 101 and the drain electrode serve as the storage capacitor, such that the writing of data is achieved. During the reading operation, a second level is applied to the secondary gate electrode 101 by the word line 30 using the influence of the voltage of the secondary gate electrode 101 on the threshold voltage of the transistor, and then the reading of data is achieved by detecting the magnitude of an output current of the transistor. Therefore, the reading and writing of data are achieved by providing only one transistor in the storage unit 10, and there is no need to provide other transistors or capacitors, which greatly simplifies the structure of the storage unit 10 and is conducive to improving the integration degree and storage density of the memory 1.

The storage unit 10 in the memory 1 according to the embodiments includes only one transistor. The film layer structure of the memory 1 is described in detail hereinafter.

In some embodiments, as shown in FIG. 5 to FIG. 8, the transistor further includes a first dielectric layer 104 and a second dielectric layer 102.

The first dielectric layer 104 is disposed between the semiconductor layer 103 and the main gate electrode 105.

The second dielectric layer 102 is disposed between the secondary gate electrode 101 and the semiconductor layer 103, and between the secondary gate electrode 101 and the source electrode. The orthographic projection of the source electrode on the substrate 200 is partially overlapped with the orthographic projection of the secondary gate electrode 101 on the substrate 200.

In the memory 1 according to the embodiments, the second dielectric layer 102 serves as a dielectric material for the storage capacitor formed by the secondary gate electrode 101 and the source electrode. The first dielectric layer 104 implements an insulative layer 106 between the main gate electrode 105 and the source electrode and drain electrode.

In some embodiments, as shown in FIG. 5 to FIG. 8, the memory 1 according to the embodiments further includes a buffer layer 300. The buffer layer 300 is disposed between the substrate 200 and a film layer, closest to the substrate 200, in the transistor (e.g., the secondary gate electrode 101 in FIG. 5).

Optionally, a material of the substrate 200 includes silicon or glass, and the buffer layer 300 is made of an insulating material.

In some embodiments, as shown in FIG. 5, in the case where the main gate electrode 105 and the secondary gate electrode 101 are respectively disposed on two sides of the semiconductor layer 103 and the transistor is in the top-gate structure, the specific film layer structure is as follows.

The main gate electrode 105 is disposed on the side, away from the substrate 200, of the semiconductor layer 103, and the secondary gate electrode 101 is disposed between the substrate 200 and the semiconductor layer 103.

The transistor further includes a first insulative layer 106, a first via 107, and a second via 108.

The first insulative layer 106 is disposed on a side, away from the substrate 200, of the main gate electrode 105.

The bit line 20 is disposed on a side, away from the main gate electrode 105, of the first insulative layer 106.

The first via 107 runs through the first insulative layer 106 and the first dielectric layer 104 and is connected to the bit line 20 and the source contact region 1031 of the semiconductor layer 103. At least a portion of the entirety including the first via 107 and the source contact region 1031 of the semiconductor layer 103 forms the source electrode.

The second via 108 runs through the first insulative layer 106, the first dielectric layer 104, and the second dielectric layer 102 and is connected to the drain contact region 1032 of the semiconductor layer 103 and the secondary gate electrode 101. At least a portion of the entirety including the second via 108 and the drain contact region 1032 of the semiconductor layer 103 forms the drain electrode.

As shown in FIG. 5, in the memory 1 according to the embodiments, the bit line 20 is electrically connected to the source contact region 1031 of the semiconductor layer 103 through the first via 107 running through the first insulative layer 106 and the first dielectric layer 104. The drain contact region 1032 of the semiconductor layer 103 is electrically connected to the secondary gate electrode 101 through the second via 108 running through the second dielectric layer 102.

At least a portion of the entirety including the first via 107 and the source contact region 1031 of the semiconductor layer 103 is regarded as the source electrode. For example, a portion or all of the first via 107 is regarded as the source electrode, and a portion or all of the source contact region 1031, which has been conducted, of the semiconductor layer 103 is regarded as the source electrode.

Similarly, at least a portion of the entirety including the second via 108 and the drain contact region 1032 of the semiconductor layer 103 is regarded as the drain electrode. For example, a portion or all of the second via 108 is considered as the drain electrode, and a portion or all of the drain contact region 1032, which has been conducted, of the semiconductor layer 103 is also regarded as the drain electrode.

It should be noted that the second via 108 also runs through the first insulative layer 106 (same as the first via 107), which allows the first via 107 and the second via 108 to be acquired by sharing the same etching process, such that the process is further reduced, and thus the production cost is reduced.

Optionally, the second via 108 and the first via 107 are made of the same material. In this way, the first via 107 and the second via 108 are prepared by sharing the same deposition process, such that the process is further reduced, and thus the production cost is reduced.

In some embodiments, as shown in FIG. 6, in a case where the main gate electrode 105 and the secondary gate electrode 101 are respectively disposed on two sides of the semiconductor layer 103 and the transistor is in the bottom-gate structure, the specific film layer structure is as follows.

The main gate electrode 105 is disposed between the substrate 200 and the semiconductor layer 103, and the secondary gate electrode 101 is disposed on the side, away from the substrate 200, of the semiconductor layer 103.

The transistor further includes a first insulative layer 106, a first via 107, and a second via 108.

The first insulative layer 106 is disposed on the side, away from the substrate 200, of the secondary gate electrode 101.

The bit line 20 is disposed on a side, away from the secondary gate electrode 101, of the first insulative layer 106.

The first via 107 runs through the first insulative layer 106 and the second dielectric layer 102 and is connected to the bit line 20 and the source contact region 1031 of the semiconductor layer 103. At least a portion of the entirety including the first via 107 and the source contact region 1031 of the semiconductor layer 103 forms the source electrode.

The second via 108 runs through the first insulative layer 106 and the second dielectric layer 102 and is connected to the secondary gate electrode 101 and the drain contact region 1032 of the semiconductor layer 103. At least a portion of the entirety including the second via 108 and the drain contact region 1032 of the semiconductor layer 103 forms the drain electrode.

In some embodiments, the word line 30 is disposed in the same layer as the main gate electrode 105 and is disposed in a different layer from the bit line 20.

As shown in FIG. 6, in the memory 1 according to the embodiments, the word line 30 and the bit line 20 are disposed in different layers, which facilitates the insulation between the two, and the word line 30 and the main gate electrode 105 are disposed in the same layer, which is conducive to further reducing the process, thereby further reducing the production cost. In some embodiments, the semiconductor layer 103 includes at least one material among a metal oxide semiconductor, monocrystalline silicon, polycrystalline silicon, or amorphous silicon. The metal oxide semiconductor includes at least one element among indium, gallium, zinc, tin, or tungsten.

In the memory 1 according to the embodiments, the material of the semiconductor layer 103 includes metal oxide. Due to the inherent characteristics of the metal oxide semiconductor (factors such as lower electronic mobility), in a case where the semiconductor layer 103 is made of metal oxide, the leakage current of the transistor is small, and the rate of charge loss on the storage capacitance is reduced. In this way, the data retention time of the memory 110 is prolonged, which is conducive to lowering the refresh frequency and power consumption of the memory 110.

Specifically, the material of the metal oxide is indium gallium zinc oxide (IGZO). In a case where the material of the metal oxide is IGZO, the leakage current of the transistor is small (the leakage current is less than or equal to 10⁻¹⁵ A), such that a low refresh rate of the memory 1 is ensured. It should be noted that the metal oxide material may be ITO, IWO, ZnOx, InOx, In2O3, InWO, SnO2, TiOx, InSnOx, ZnxOyNz, MgxZnyOz, InxZnyOz, InxGayZnzOa, ZrxInyZnzOa, HfxInyZnzOa, SnxInyZnzOa, AlxSnyInzZnaOd, SixInyZnzOa, ZnxSnyOz, AlxZnySnzOa, GaxZnySnzOa, ZrxZnySnzOa, InGaSiO, or other materials, which is adjusted according to actual needs as long as the leakage current of the transistor meets the requirement.

To further improve the integration degree of the memory 1, the memory 1 includes a plurality of storage units 10. In some embodiments, at least two storage units 10 are stacked in a direction perpendicular to the substrate 200.

Optionally, as shown in FIG. 4 to FIG. 8, the memory 1 according to some embodiments further includes a planarization layer 109 disposed on a side, away from the substrate 200, of the bit line 20. The secondary gate electrode 101 of a previous layer of storage unit group 100 is manufactured on the planarization layer 109 of a next layer of storage unit group 100, such that the storage unit groups 100 are stacked along the direction perpendicular to the substrate 200, and thus a high-density and highly integrated memory 1 is acquired.

In some embodiments, at least two storage units 10 are arranged in an array on a side of the substrate 200. The main gate electrodes 105 of the transistors in the at least two storage units 10 disposed in the same row are electrically connected to the same word line 30, and the source electrodes of the transistors in the at least two storage units 10 disposed in the same column are electrically connected to the same bit line 20.

As shown in FIG. 4, the memory 1 according to the embodiments further includes the substrate 200, wherein the plurality of word lines 30, the plurality of bit lines 20, and the plurality of storage units 10 are arranged on a side of the substrate 200. The plurality of storage units 10 are organized into a plurality of storage unit groups 100, and the plurality of storage unit groups 100 are arranged in the direction perpendicular to the substrate 200. Each of the storage unit groups 100 includes a plurality of storage units 10 arranged in an array in a direction parallel to the substrate 200. The gate electrodes of the transistors in the storage units 10 disposed in the same row are electrically connected to the same word line 30, and the source electrodes of the transistors in the storage units 10 disposed in the same column are electrically connected to the same bit line 20.

It should be noted that, in a specific implementation process, different arrangement methods are selected according to the specific requirement of the storage capacity and the space limitation of the memory 1. That is, an optimized design of the storage capacity and the storage space is achieved by adjusting the number of storage unit groups 100 and the number of storage units 10 in each storage unit group 100 (including adjusting the number of storage units 10 in each row and/or each column).

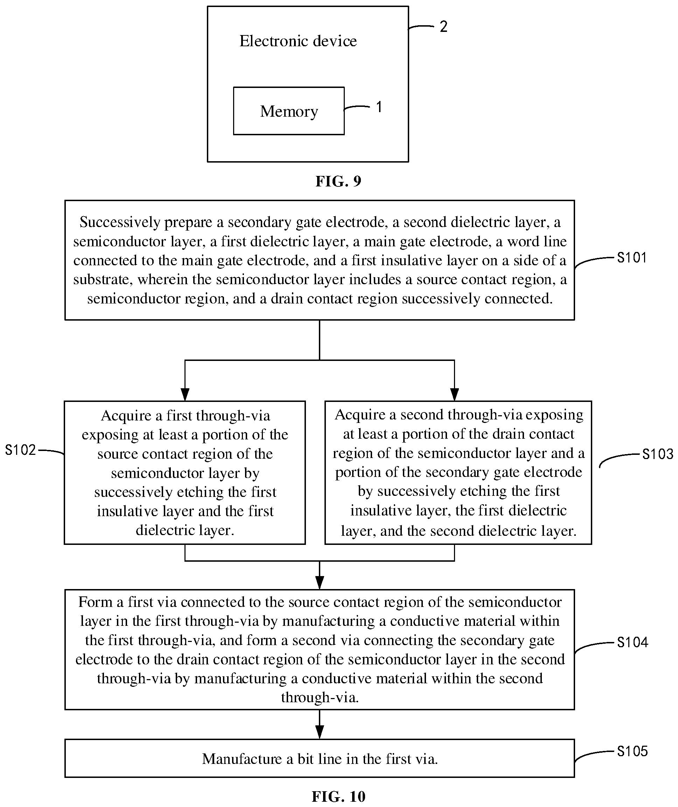

Based on the same inventive concept, an electronic device 2 is provided according to some embodiments of the present disclosure. As shown in FIG. 9, the electronic device 2 includes the memory 1 according to any one of the above embodiments and has the beneficial effects of the memory 1 described above, which are not repeated herein.

Optionally, the electronic device in the embodiments of the present disclosure includes a storage device, a smartphone, a computer, a tablet computer, an artificial intelligence device, a wearable device, or a mobile power source electrode.

Based on the same inventive concept, a method for manufacturing the memory 1 is provided according to some embodiments of the present disclosure. As shown in FIG. 10, the method includes the following steps S101 to S105.

In S101, a secondary gate electrode, a second dielectric layer, a semiconductor layer, a first dielectric layer, a main gate electrode, a word line connected to the main gate electrode, and a first insulative layer are successively prepared on a side of a substrate, wherein the semiconductor layer includes a source contact region, a semiconductor region, and a drain contact region successively connected.

In some embodiments, successively preparing the secondary gate electrode, the second dielectric layer, the semiconductor layer, the first dielectric layer, the main gate electrode, the word line connected to the main gate electrode, and the first insulative layer on the side of the substrate in step S101 includes the following steps.

The secondary gate electrode is prepared on the side of the substrate. Optionally, this step forms the secondary gate electrode 101 by depositing a first metal layer and patterning the first metal layer.

The second dielectric layer is prepared on the secondary gate electrode and the exposed substrate. Optionally, the second dielectric layer 102 is prepared using a full coating process.

The semiconductor layer is prepared on the second dielectric layer, such that an orthographic projection of the semiconductor region of the semiconductor layer on the substrate and an orthographic projection of the source contact region of the semiconductor layer on the substrate are each partially overlapped with an orthographic projection of the secondary gate electrode on the substrate. Optionally, the semiconductor layer 103 is formed by depositing a metal oxide layer on the second dielectric layer 102 and patterning the metal oxide layer.

The source contact region and the drain contact region of the semiconductor layer are conducted.

In S102, a first through-via exposing at least a portion of the source contact region of the semiconductor layer is acquired by successively etching the first insulative layer and the first dielectric layer. Thereafter, step S104 is performed.

In S103, a second through-via exposing at least a portion of the drain contact region of the semiconductor layer and a portion of the secondary gate electrode is acquired by successively etching the first insulative layer, the first dielectric layer, and the second dielectric layer. Thereafter, step S104 is performed.

In some embodiments, the step of acquiring the first through-via exposing at least a portion of the source contact region of the semiconductor layer by successively etching the first insulative layer and the first dielectric layer and the step of acquiring the second through-via exposing at least a portion of the drain contact region of the semiconductor layer and a portion of the secondary gate electrode by successively etching the first insulative layer, the first dielectric layer, and the second dielectric layer are performed synchronously. In this way, the first via 107 and the second via 108 are prepared by sharing the same etching process, which is conducive to further reducing the process and thereby reducing the production cost.

It should be noted that the execution order of step S102 and step S103 is not limited herein, and it is also possible to perform step S 102 first or step S 103 first.

In S104, a first via connected to the source contact region of the semiconductor layer is formed in the first through-via by manufacturing a conductive material within the first through-via, and a second via connecting the secondary gate electrode to the drain contact region of the semiconductor layer is formed in the second through-via by manufacturing a conductive material within the second through-via.

In some embodiments, the conductive materials respectively within the first through-via and the second through-via are the same, such as the same type of metallic material.

In S105, a bit line is manufactured in the first via.

In some embodiments, a plurality of bit lines 20 are formed by depositing a third metal layer and patterning this third metal layer. The bit line 20 is electrically connected to the source electrode through a first through-path (i.e., the first via 107).

After steps S101 to S105, a memory is prepared. The transistor in the memory adopts a top-gate structure, and the main gate electrode and the secondary gate electrode are respectively disposed on two sides of the semiconductor layer.

In the method for manufacturing the memory according to the embodiments, because the storage unit 10 in the memory includes only one transistor, the number of film layers is reduced, which is conducive to reducing the process and lowering the production cost. Further, the reading and writing of data are achieved by providing only one transistor in the storage unit 10, and there is no need to provide additional transistors or capacitor devices, such that the structure of the storage unit 10 is greatly simplified, which is conducive to improving the integration degree and storage density of the dynamic memory.

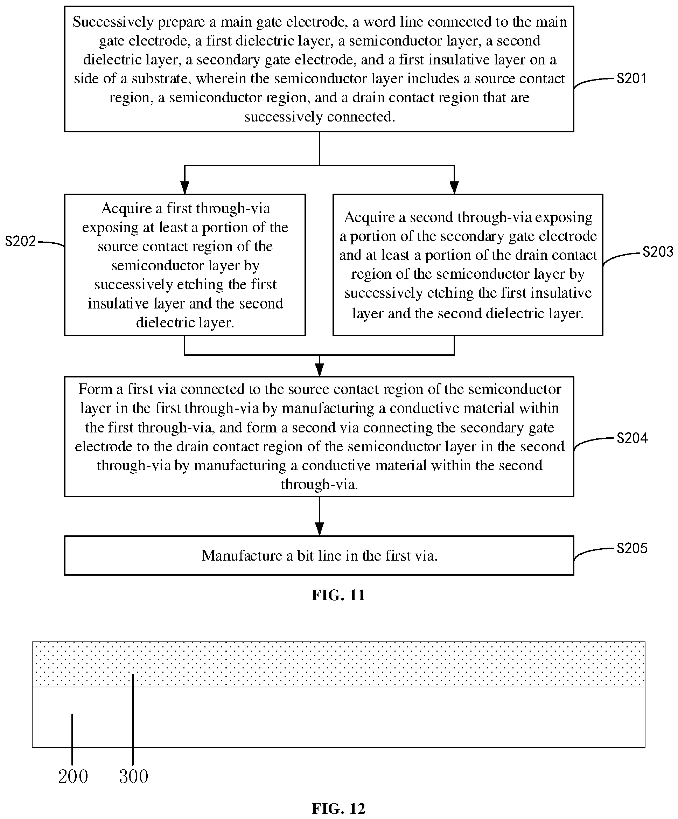

Based on the same inventive concept, another method for manufacturing a memory is provided according to some embodiments of the present disclosure. As shown in FIG. 11, the method includes the following steps S201 to S205.

In S201, a main gate electrode, a word line connected to the main gate electrode, a first dielectric layer, a semiconductor layer, a second dielectric layer, a secondary gate electrode, and a first insulative layer are successively prepared on a side of a substrate, wherein the semiconductor layer includes a source contact region, a semiconductor region, and a drain contact region that are successively connected.

In some embodiments, successively preparing the main gate electrode, the word line connected to the main gate electrode, the first dielectric layer, the semiconductor layer, the second dielectric layer, the secondary gate electrode, and the first insulative layer on the side of the substrate includes the following steps.

The main gate electrode and the word line connected to the main gate electrode are prepared on the side of the substrate. Optionally, this step forms the main gate electrode and the word line connected to the main gate electrode by depositing a second metal layer and patterning the second metal layer.

The first dielectric layer is prepared on the main gate electrode, the word line connected to the main gate electrode, and the exposed substrate. Optionally, the first dielectric layer is prepared by using a full coating process.

The semiconductor layer is prepared on the first dielectric layer, such that an orthographic projection of the semiconductor region of the semiconductor layer on the substrate is partially overlapped with an orthographic projection of the main gate electrode on the substrate. Optionally, the semiconductor layer is formed by depositing a metal oxide layer on the first dielectric layer and then patterning the metal oxide layer.

The source contact region and the drain contact region of the semiconductor layer are conducted.

The second dielectric layer is prepared on the semiconductor layer and the exposed first dielectric layer. Optionally, the second dielectric layer is prepared by using a full coating process.

The secondary gate electrode is prepared on the second dielectric layer, such that an orthographic projection of the secondary gate electrode on the substrate is partially overlapped with the orthographic projection of the semiconductor region of the semiconductor layer on the substrate and an orthographic projection of the source contact region of the semiconductor layer on the substrate. Optionally, this step forms the secondary gate electrode 101 by depositing a first metal layer and patterning the first metal layer.

In S202, a first through-via exposing at least a portion of the source contact region of the semiconductor layer is acquired by successively etching the first insulative layer and the second dielectric layer. Thereafter step S204 is performed.

In S203, a second through-via exposing a portion of the secondary gate electrode and at least a portion of the drain contact region of the semiconductor layer is acquired by successively etching the first insulative layer and the second dielectric layer. Thereafter step S204 is then performed.

In some embodiments, the step of acquiring the first through-via exposing at least a portion of the source contact region of the semiconductor layer by successively etching the first insulative layer and the second dielectric layer and the step of acquiring the second through-via exposing a portion of the secondary gate electrode and at least a portion of the drain contact region of the semiconductor layer by successively etching the first insulative layer and the second dielectric layer are performed synchronously. In this way, the first via 107 and the second via 108 are prepared by sharing the same etching process, which is conducive to further reducing the process and thereby reducing the production cost.

It should be noted that the execution order of step S202 and step S203 is not limited herein, and it is also possible to perform step S202 first or step S203 first.

In S204, a first via connected to the source contact region of the semiconductor layer is formed in the first through-via by manufacturing a conductive material within the first through-via, and a second via connecting the secondary gate electrode to the drain contact region of the semiconductor layer is formed in the second through-via by manufacturing a conductive material within the second through-via.

In some embodiments, the conductive materials respectively within the first through-via and the second through-via are the same, such as the same type of metallic material.

In S205, a bit line is manufactured in the first via.

In some embodiments, a plurality of bit lines 20 are formed by depositing a third metal layer and patterning the third metal layer. The bit line 20 is electrically connected to the source electrode through a first through-path (i.e., the first via 107).

After steps S201 to S205, another memory is prepared. The transistor in the memory adopts a bottom-gate structure, and the main gate electrode and the secondary gate electrode are respectively disposed on two sides of the semiconductor layer.

For ease of understanding, some embodiments of the present disclosure further also provide a specific method for manufacturing a memory. This method is applicable to manufacturing the memory in a top-gate structure, and the method includes the following steps S301 to S310.

In S301, a substrate 200 is provided, and a buffer layer 300 is formed on the substrate 200. The film layer structure after this step S301 is shown in FIG. 12.

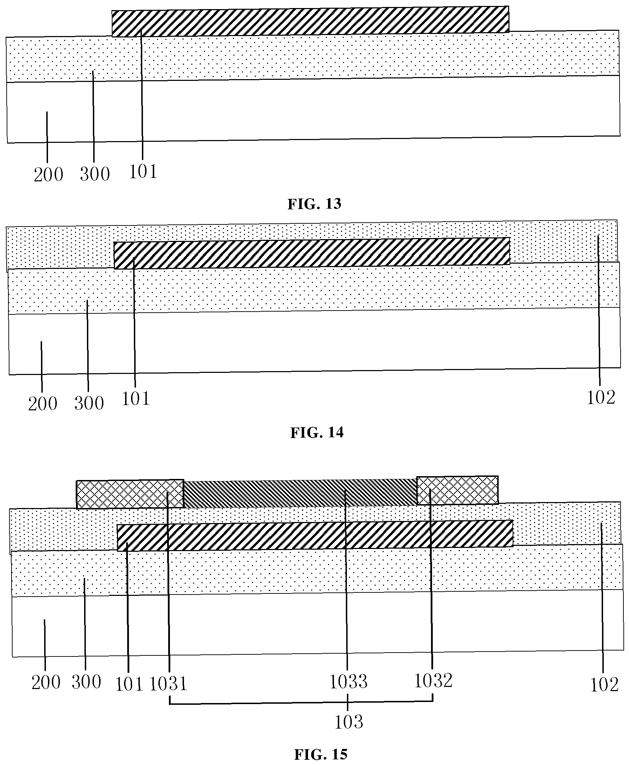

In S302, a plurality of secondary gate electrodes 101 are formed on the substrate 200 by a patterning process. The film layer structure after this step S302 is shown in FIG. 13.

In S303, a second dielectric layer 102 is formed on the secondary gate electrode 101. The film layer structure after this step S303 is shown in FIG. 14.

In S304, a metal oxide is deposited on the second dielectric layer 102 to serve as a semiconductor layer 103, such that an orthographic projection of a semiconductor region of the semiconductor layer on the substrate and an orthographic projection of a source contact region of the semiconductor layer on the substrate are each partially overlapped with an orthographic projection of the secondary gate electrode on the substrate. The film layer structure after this step S304 is shown in FIG. 15.

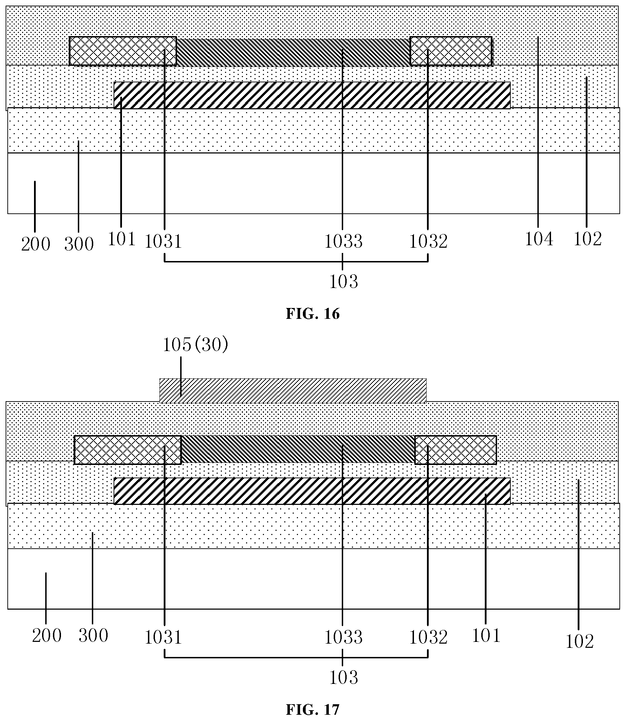

In S305, a first dielectric layer 104 is formed on the semiconductor layer 103. The film layer structure after this step S305 is shown in FIG. 16.

In S306, a plurality of main gate electrodes 105 and word lines 30 connected to the main gate electrodes 105 are formed on the first dielectric layer 104 by a patterning process. The film layer structure after this step S306 is shown in FIG. 17.

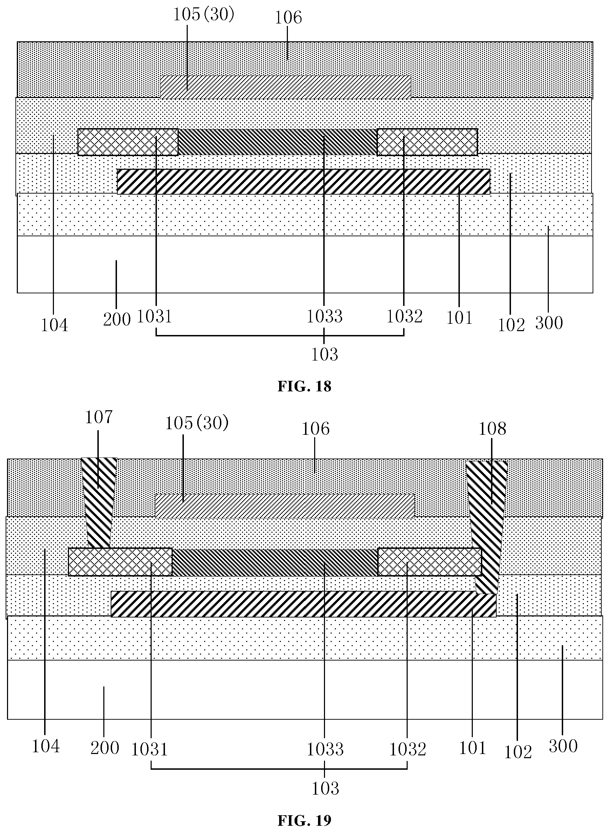

In S307, an insulative layer 106 is formed on the main gate electrodes 105. The film layer structure after this step S307 is shown in FIG. 18.

In S308, a first via 107 running through the insulative layer 106 and the first dielectric layer 104 and a second via 108 running through the insulative layer 106, the first dielectric layer 104, the semiconductor layer 103, and the second dielectric layer 102 are formed. At least a portion of the entirety including the first via and the source contact region of the semiconductor layer forms the source electrode, and at least a portion of the entirety including the second via and the drain contact region of the semiconductor layer forms the drain electrode. The film layer structure after this step S308 is shown in FIG. 19.

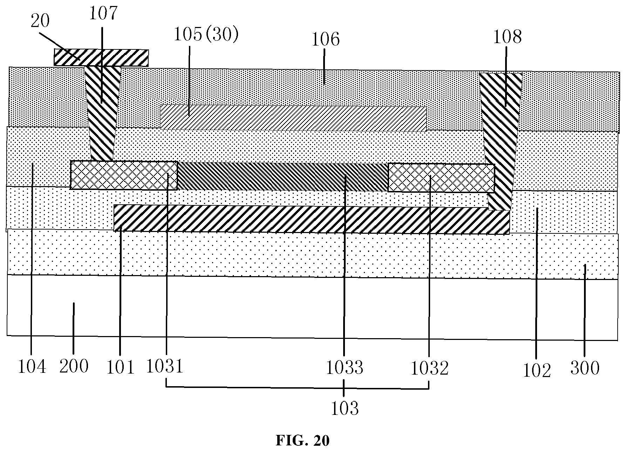

In S309, a plurality of bit lines 20 are formed by a patterning process, and the bit lines 20 are electrically connected to the source contact region of the semiconductor layer through the first via 107. The film layer structure after this step S309 is shown in FIG. 20.

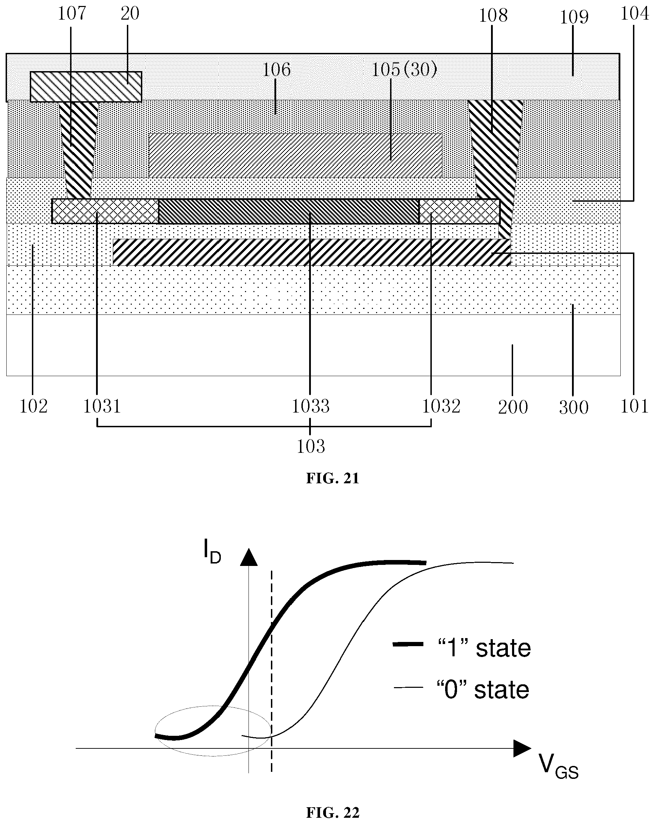

In S310, a planarization layer 109 is formed on a side, away from the substrate 200, of the bit lines 20. The film layer structure after this step S310 is shown in FIG. 21.

It should be appreciated that the dynamic memory including a plurality of storage units stacked in a direction perpendicular to the substrate is acquired by repeatedly performing steps S302 to S310 on the planarization layer 109. During the formation of the storage units in the lowermost layer, a plurality of secondary gate electrodes 101 are formed on the buffer layer 300 by a patterning process. During the formation of the other storage units, a plurality of secondary gate electrodes 101 are formed on the planarization layer 109 of the storage units of the next layer by a patterning process.

Based on the same inventive conception, a method for reading and writing is provided according to some embodiments of the present disclosure. The method is applicable to reading and writing the memory in the above embodiments. The method includes T1-T2.

In T1, during a writing state, a first level is applied to the main gate electrode 105 of the to-be-written storage unit 10 by the word line 30, such that the transistor is on. Moreover, a storage signal is transmitted to the source electrode of the to-be-written storage unit 10 by the bit line 20, such that the storage signal is written to the storage unit 10 as stored data.

In a case where the dynamic memory is in a writing mode of operation, the first level (e.g., 5V, the specific value of which is adjusted according to the actual needs) is applied to the main gate electrode 105 by the word line 30, such that the transistor is in an on state. The magnitude of the first level is related to factors such as the structure of the transistor and the material of the semiconductor layer 103 in the transistor, which is adjusted according to the actual needs.

In the case where the transistor is on, based on external input data, a voltage is applied to the source electrode by the bit line 20, the source electrode and the drain electrode are conducted through the semiconductor layer 103, and the drain electrode and the secondary gate electrode 101 are electrically connected, and thus the magnitude of the voltages on the source electrode and the drain electrode is the same as the magnitude of the voltage on the secondary gate electrode 101 (the potential of the drain electrode is the same as the potential of the secondary gate electrode 101). The node capacitance of the secondary gate electrode 101 and the gate electrode forms the storage capacitance of the storage unit 10, and the level of the voltage on the secondary gate electrode 101 determines the quantity of the charges in the storage capacitance, which in turn determines whether the binary of the data signal stored in the storage unit 10 is 0 or 1. In a case where a high voltage (e.g., 5 V) is applied to the source electrode by the bit line 20, the data "1 " is written to the storage unit 10, and in a case where a low voltage (e.g., 0V) is applied to the source electrode by the bit line 20, the data "0" is written to the storage unit 10.

In T2, during a reading state, a second level is applied to the main gate electrode 105 of the to-be-read storage unit 10 by the word line 30 to cause the bit line 20 to sense the stored data of the to-be-read storage unit 10.

In a case where the dynamic memory is in a reading mode of operation, the second level is applied to the main gate electrode 105 by the word line 30, such that a voltage difference exits between the main gate electrode 105 and the source electrode, and at the same time, the reading of data is achieved by detecting the magnitude of the current (i.e., the output current of the transistor) on the bit line 20.

Specifically, in a case where the data "1" is stored in the storage unit 10, the secondary gate electrode 101 and the gate electrode have a high potential, and the transistor is in an on state under the combined effect of the first level and the second level, such that a more significant current is measured by the bit line 20. In a case where the more significant current is measured, it is determined that the read data is "1." In a case where the data stored in the storage unit 10 is "0," the secondary gate electrode 101 and the drain electrode have a low potential. After the second level is applied to the main gate electrode 105, the transistor is still in an off state, and thus the current measured by the bit line 2032 is very weak. In this case, it is determined that the read data is "0."

It should be noted that the magnitude of the threshold voltage of the transistor is related to the magnitude of the potentials on the secondary gate electrode 101 and the drain electrode. For an N-type field effect transistor (where the carriers are electrons when the transistor is on), the higher the potentials on the secondary gate electrode 101 and the drain electrode, the lower the threshold voltage. That is, the transistor is conducted even though the voltage difference between the main gate electrode 105 and the source electrode is small. The lower the potentials on the secondary gate electrode 101 and the drain electrode, the higher the threshold voltage.

As shown in FIG. 21, the horizontal coordinate in FIG. 21 is the voltage applied to the main gate electrode 105 (i.e., the second level) and the vertical coordinate is the output current of the transistor. In a case where the second level applied to the main gate electrode 105 is a particular value (the position of the dashed line in FIG. 21), the level of the voltages on the secondary gate electrode 101 and the drain electrode (i.e., whether the data written to the transistor is "1" or "0") causes the magnitude of the output current of the transistor (i.e., the current measured by the bit line 20) to vary significantly. The data is read out from the storage unit 10 by detecting the current on the bit line 20. In a case where the transistor writes data "1," the output current of the transistor is large, and therefore the read data is "1." In a case where the transistor writes data "0," the output current of the transistor is extremely weak, and therefore the data read is also "0."

The value of the second level is determined based on the parameters of the transistor and the magnitude of the voltages applied to the secondary gate electrode 101 and the gate electrode during the writing operation. It should be noted that the value of the second level needs to be appropriate (it needs to be between the threshold voltage of the transistor when storing "1" and the threshold voltage of the transistor when storing "0"). If the value of the second level is not appropriate, the magnitude of the output current of the transistor when storing data "1" (i.e., when the potentials on the drain electrode and secondary gate electrode 101 are high) and the magnitude of the output current of the transistor when storing data "0" (i.e., when the potentials on the drain electrode and secondary gate electrode 101 are low) will be very close, and thus it is difficult to determine whether the read data is "0" or "1" during the reading operation, which affects the performance of the dynamic memory. The optimum value of the second level is determined by experiments or simulation to maximize the difference in the output currents of the transistor when performing the reading operation in different states, such that the reading performance is improved.

At least the following beneficial effects are achieved by applying the embodiments of the present disclosure.

1. In the storage unit according to the present disclosure, the transistor, on the basis of including the main gate electrode capable of controlling the conductivity of the semiconductor layer, is introduced with the secondary gate electrode that is also capable of controlling the conductivity of the semiconductor layer. The secondary gate electrode is electrically coupled to the drain electrode, such that the secondary gate electrode acquires a constant potential synchronized with the drain electrode and provides supplementary control to the semiconductor layer by using the constant potential. Furthermore, the secondary gate electrode is not electrically connected to the source electrode, such that the secondary gate electrode serves as a negative bias of the threshold voltage during the reading stage, which improves the performance of the transistor and thus optimizes the reading and writing performance of the memory.

The storage unit according to the present disclosure includes the capacitance storage structure formed between the secondary gate electrode and the first electrode, which achieves the writing of data and also improves the current leakage in the off state of the transistor. The device has a high degree of integration by using the secondary electrode as part of the capacitance storage structure.

In the storage unit according to the present disclosure, the source electrode of the transistor is utilized as another part of the capacitance storage structure to cooperate with the secondary gate electrode 101 to achieve the writing of data, such that the integration degree of the memory is further improved. That is, the reading and writing of data are achieved by providing only one transistor in the storage unit of the memory, and there is no need to provide other transistors or capacitors, which greatly simplifies the structure of the storage unit and is conducive to improving the integration and storage density of the memory.

It should be understood by those skilled in the art that the steps, measures, and solutions in the operations, methods, and flows already discussed in the present disclosure can be alternated, changed, combined, or deleted. Further, other steps, measures, and solutions in the operations, methods, and flows already discussed in the present disclosure can also be alternated, changed, rearranged, decomposed, combined, or deleted. Further, the steps, measures, and solutions in the operations, methods, and flows disclosed in the present disclosure that are available in the related art can also be alternated, changed, rearranged, decomposed, combined, or deleted.

In the description of the present disclosure, the orientation or positional relationship indicated by the terms "upper," "lower," "vertical," "horizontal," or the like is an exemplary orientation or positional relationship shown based on the accompanying drawings, merely for describing the embodiments of the present disclosure or simplifying the description, rather than indicating or implying that the specified device or component must have a particular orientation or be constructed and operated in a particular orientation. Therefore, it should not be interpreted as any limitation to the present disclosure.

The terms "first" and "second" are merely for illustrative purposes, and should not be interpreted as indicating or implying the relative importance or implicitly indicating the number of the specified technical features. Therefore, the features defined by the term "first" or "second" may explicitly or implicitly include one or more features. In the description of the present disclosure, unless otherwise stated, "a plurality of" refers to two or more.

It should be noted that, unless otherwise expressly specified and defined, the terms "mount," "joint" and "connect" should be interpreted in a broad sense. For example, the connection may be a fixed connection, detachable connection, or integral connection; or may be a direct connection or indirect connection through an intermediate member; or may be internal communication between two elements. Those skilled in the art should understand the specific meanings of the terms in the present disclosure according to the specific situation.

In the description of the specification, specific features, structures, materials, or characteristics can be combined appropriately in any one or more embodiments or examples.

It should be understood that, although the steps in the flowcharts of the accompanying drawings are shown successively as indicated by arrows, the implementation order of these steps is not limited to the order indicated by the arrows. Unless explicitly stated herein, in some implementation scenarios of the embodiments of the present disclosure, the steps in the flowcharts may be executed in other orders as required. In addition, based on the actual implementation scenario, some or all of the steps in the flowcharts may include a plurality of sub-steps or stages. Some or all of these sub-steps or stages may be executed at the same moment or may be executed at different moments. In a scenario where the sub-steps or stages are executed at different moments, the execution order of these sub-steps or stages may be flexibly configured according to the requirements. It will not be limited to the embodiments of the present disclosure.

The above description merely shows some implementations of the present disclosure. It should be pointed out that, for those skilled in the art, without departing from the technical concept of the solutions of the present disclosure, the use of other similar implementation means based on the technical concept of the present disclosure also belongs to the protection scope of the embodiments of the present disclosure.

## Claims

1. A memory, comprising: a substrate, and a word line, a bit line, and a storage unit that are disposed on a side of the substrate;
wherein the storage unit comprises a transistor, the transistor comprising:
a semiconductor layer, comprising a source contact region, a semiconductor region, and a drain contact region that are successively connected;
a main gate electrode, electrically connected to the word line;
a source electrode, electrically connected to the bit line and the source contact region of the semiconductor layer;
a drain electrode, electrically connected to the drain contact region of the semiconductor layer;
a secondary gate electrode, electrically connected to the drain electrode;
wherein an orthographic projection of the main gate electrode on the substrate and an orthographic projection of the secondary gate electrode on the substrate are each at least partially overlapped with an orthographic projection of the semiconductor region of the semiconductor layer on the substrate.

2. The memory according to claim 1, wherein
the main gate electrode is disposed between the substrate and the semiconductor layer; or
the main gate electrode is disposed on a side, away from the substrate, of the semiconductor layer.

3. The memory according to claim 1 or 2, wherein the main gate electrode and the secondary gate electrode are respectively disposed on opposite sides of the semiconductor layer.

4. The memory according to claim 1, wherein the storage unit further comprises a storage structure;
wherein the storage structure comprises a capacitance storage structure formed between the secondary gate electrode and a first electrode.

5. The memory according to claim 4, wherein the first electrode is the source electrode, and an orthographic projection of the source electrode on the substrate is partially overlapped with the orthographic projection of the secondary gate electrode on the substrate.

6. The memory according to claim 4, wherein the main gate electrode is disposed on a side, away from the substrate, of the semiconductor layer, the secondary gate electrode is disposed between the substrate and the semiconductor layer, and the first electrode is disposed between the substrate and the secondary gate electrode.

7. The memory according to claim 4, wherein the main gate electrode is disposed between the substrate and the semiconductor layer, the secondary gate electrode is disposed on a side, away from the substrate, of the semiconductor layer, and the first electrode is disposed on a side, away from the substrate, of the secondary gate electrode.

8. The memory according to claim 1, wherein the transistor further comprises:
a first dielectric layer disposed between the semiconductor layer and the main gate electrode; and
a second dielectric layer disposed between the secondary gate electrode and the semiconductor layer and disposed between the secondary gate electrode and the source electrode, wherein an orthographic projection of the source electrode on the substrate is partially overlapped with the orthographic projection of the secondary gate electrode on the substrate.

9. The memory according to claim 8, wherein
the main gate electrode is disposed on a side, away from the substrate, of the semiconductor layer, and the secondary gate electrode is disposed between the substrate and the semiconductor layer; and
the transistor further comprises a first insulative layer, a first via, and a second via; wherein
the first insulative layer is disposed on a side, away from the substrate, of the main gate electrode;
the bit line is disposed on a side, away from the main gate electrode, of the first insulative layer;
the first via runs through the first insulative layer and the first dielectric layer and is connected to the bit line and the source contact region of the semiconductor layer, wherein at least a portion of an entirety comprising the first via and the source contact region of the semiconductor layer forms the source electrode; and
the second via runs through the first insulative layer, the first dielectric layer, and the second dielectric layer and is connected to the drain contact region of the semiconductor layer and the secondary gate electrode, wherein at least a portion of an entirety comprising the second via and the drain contact region of the semiconductor layer forms the drain electrode.

10. The memory according to claim 8, wherein
the main gate electrode is disposed between the substrate and the semiconductor layer, and the secondary gate electrode is disposed on a side, away from the substrate, of the semiconductor layer; and
the transistor further comprises a first insulative layer, a first via, and a second via; wherein
the first insulative layer is disposed on a side, away from the substrate, of the secondary gate electrode;
the bit line is disposed on a side, away from the secondary gate electrode, of the first insulative layer;
the first via runs through the first insulative layer and the second dielectric layer and is connected to the bit line and the source contact region of the semiconductor layer, wherein at least a portion of an entirety comprising the first via and the source contact region of the semiconductor layer forms the source electrode; and
the second via runs through the first insulative layer and the second dielectric layer and is connected to the secondary gate electrode and the drain contact region of the semiconductor layer, wherein at least a portion of an entirety comprising the second via and the drain contact region of the semiconductor layer forms the drain electrode.

11. The memory according to claim 1, wherein the word line is disposed in a same layer as the main gate electrode and is disposed in a different layer from the bit line.

12. The memory according to claim 1, wherein the semiconductor layer comprises at least one material of a metal oxide semiconductor, monocrystalline silicon, polycrystalline silicon, or amorphous silicon;
wherein the metal oxide semiconductor comprises at least one of indium, gallium, zinc, tin, or tungsten.

13. The memory according to claim 1, wherein
at least two of the storage units are stacked in a direction perpendicular to the substrate; and/or
at least two of the storage units are arranged in an array on a side of the substrate, wherein the main gate electrodes of the transistors in at least two of the storage units disposed in a same row are electrically connected to a same one of the word lines, and the source electrodes of the transistors in at least two of the storage units disposed in a same column are electrically connected to a same one of the bit lines.

14. An electronic device, comprising: the memory as defined in any one of claims 1 to 13.

15. A method for manufacturing a memory, comprising:
successively preparing a secondary gate electrode, a second dielectric layer, a semiconductor layer, a first dielectric layer, a main gate electrode, a word line connected to the main gate electrode, and a first insulative layer on a side of a substrate; wherein the semiconductor layer comprises a source contact region, a semiconductor region, and a drain contact region that are successively connected;
acquiring a first through-via exposing at least a portion of the source contact region of the semiconductor layer by successively etching the first insulative layer and the first dielectric layer;
acquiring a second through-via exposing at least a portion of the drain contact region of the semiconductor layer and a portion of the secondary gate electrode by successively etching the first insulative layer, the first dielectric layer, and the second dielectric layer;
forming a first via connected to the source contact region of the semiconductor layer within the first through-via and a second via connecting the secondary gate electrode to the drain contact region of the semiconductor layer within the second through-via by manufacturing conductive materials within the first through-via and the second through-via, respectively; and
manufacturing a bit line in the first via.

16. The method for manufacturing the memory according to claim 15, wherein successively preparing the secondary gate electrode, the second dielectric layer, the semiconductor layer, the first dielectric layer, the main gate electrode, the word line connected to the main gate electrode, and the first insulative layer on the side of the substrate comprises:
preparing the secondary gate electrode on the side of the substrate;
preparing the second dielectric layer on the secondary gate electrode and the substrate exposed;
preparing the semiconductor layer on the second dielectric layer, such that an orthographic projection of the semiconductor region of the semiconductor layer on the substrate and an orthographic projection of the source contact region of the semiconductor layer on the substrate are each partially overlapped with an orthographic projection of the secondary gate electrode on the substrate; and
conducting the source contact region and the drain contact region of the semiconductor layer.

17. The method for manufacturing the memory according to claim 15 or 16, wherein
acquiring the first through-via exposing at least a portion of the source contact region of the semiconductor layer by successively etching the first insulative layer and the first dielectric layer and acquiring the second through-via exposing at least a portion of the drain contact region of the semiconductor layer and a portion of the secondary gate electrode by successively etching the first insulative layer, the first dielectric layer, and the second dielectric layer are performed synchronously.

18. A method for manufacturing a memory, comprising:
successively preparing a main gate electrode, a word line connected to the main gate electrode, a first dielectric layer, a semiconductor layer, a second dielectric layer, a secondary gate electrode, and a first insulative layer on a side of a substrate; wherein the semiconductor layer comprises a source contact region, a semiconductor region, and a drain contact region that are successively connected;
acquiring a first through-via exposing at least a portion of the source contact region of the semiconductor layer by successively etching the first insulative layer and the second dielectric layer;
acquiring a second through-via exposing a portion of the secondary gate electrode and at least a portion of the drain contact region of the semiconductor layer by successively etching the first insulative layer and the second dielectric layer;
forming a first via connected to the source contact region of the semiconductor layer in the first through-via and a second via connecting the secondary gate electrode to the drain contact region of the semiconductor layer in the second through-via by respectively manufacturing conductive materials in the first through-via and the second through-via; and
manufacturing a bit line in the first via.

19. The method for manufacturing the memory according to claim 18, wherein successively preparing the main gate electrode, the word line connected to the main gate electrode, the first dielectric layer, the semiconductor layer, the second dielectric layer, the secondary gate electrode, and the first insulative layer on the side of the substrate comprises:
preparing the main gate electrode and the word line connected to the main gate electrode on the side of the substrate;
preparing the first dielectric layer on the main gate electrode, the word line connected to the main gate electrode, and the exposed substrate;
preparing the semiconductor layer on the first dielectric layer, such that an orthographic projection of the semiconductor region of the semiconductor layer on the substrate is partially overlapped with an orthographic projection of the main gate electrode on the substrate;
conducting the source contact region and the drain contact region of the semiconductor layer;
preparing the second dielectric layer on the semiconductor layer and the exposed first dielectric layer; and
preparing the secondary gate electrode on the second dielectric layer, such that an orthographic projection of the secondary gate electrode on the substrate is partially overlapped with the orthographic projection of the semiconductor region of the semiconductor layer on the substrate and an orthographic projection of the source contact region of the semiconductor layer on the substrate

20. The method for manufacturing the memory according to claim 18 or 19, wherein acquiring the first through-via exposing at least a portion of the source contact region of the semiconductor layer by successively etching the first insulative layer and the second dielectric layer and acquiring the second through-via exposing a portion of the secondary gate electrode and at least a portion of the drain contact region of the semiconductor layer by successively etching the first insulative layer and the second dielectric layer are performed synchronously.
